(19) Europäisches Patentamt
European Patent Office
Office européen des brevets

(11) **EP 2 679 962 B1**

(12) **EUROPÄISCHE PATENTSCHRIFT**

(45) Veröffentlichungstag und Bekanntmachung des Hinweises auf die Patenterteilung:
**23.11.2016 Patentblatt 2016/47**

(51) Int Cl.:
*G01D 5/38* (2006.01)     *G03F 7/20* (2006.01)
*H01L 21/67* (2006.01)

(21) Anmeldenummer: **13169683.3**

(22) Anmeldetag: **29.05.2013**

(54) **Positionsmesseinrichtung**

Position measuring device

Dispositif de mesure de position

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.06.2012 DE 102012210309**

(43) Veröffentlichungstag der Anmeldung:
**01.01.2014 Patentblatt 2014/01**

(73) Patentinhaber: **Dr. Johannes Heidenhain GmbH 83301 Traunreut (DE)**

(72) Erfinder:
• **Bihr, Ralf**
  **83278 Traunstein (DE)**
• **Drescher, Jörg,**
  **83122 Samerberg (DE)**
• **Holzapfel, Wolfgang,**
  **83119 Obing (DE)**
• **Meissner, Markus,**
  **83236 Übersee (DE)**
• **Musch, Bernhard,**
  **83624 Otterfing (DE)**
• **Pletschacher, Bernhard**
  **83339 Chieming (DE)**

(56) Entgegenhaltungen:
**EP-A2- 1 762 828       EP-A2- 1 826 615**
**US-A1- 2006 227 309     US-A1- 2009 190 110**

EP 2 679 962 B1

**Beschreibung**

Die vorliegende Erfindung betrifft eine Positionsmesseinrichtung.

Zur hochpräzisen Positionserfassung von relativ zueinander beweglichen Maschinenkomponenten werden vorzugsweise optische Positionsmesseinrichtungen verwendet. Diesen umfassen eine oder mehrere optische Abtasteinheiten, die mit einer ersten Maschinenkomponente verbunden sind sowie ein oder mehrere Maßverkörperungen, die mit einer zweiten Maschinenkomponente verbunden sind, wobei die zweite Maschinenkomponente gegenüber der ersten Maschinenkomponente beweglich ist. Über die optische Abtastung der Maßverkörperung(en) mittels der Abtasteinheiten lassen sich verschiebungsabhängige Positionssignale und damit die Relativposition der Maschinenkomponenten bestimmen. Die Maßverkörperungen können hierbei als eindimensionale Maßstäbe oder aber als zweidimensionale Maßstabsplatten ausgebildet sein. In einer möglichen Anwendung sind die Abtasteinheiten der Positionsmesseinrichtung auf einer beweglichen Maschinenkomponente wie z.B. einem Tisch montiert, die unter einem Bearbeitungswerkzeug positioniert werden muss, wobei auf dem Tisch das zu bearbeitende Werkstück angeordnet ist. Das Werkstück soll über den Tisch in einer Verschiebeebene (XY-Ebene) entlang zweier Hauptbewegungsachsen X, Y verschiebbar sein, während die anderen Freiheitsgrade (Verschiebung entlang einer Z-Achse, die senkrecht zur XY-Ebene orientiert ist; Drehungen um die X-, Y- und Z-Achse) festgehalten bzw. nur leicht moduliert werden sollen. In einer Ebene parallel zur Verschiebeebene sind ein oder mehrere zweidimensionale Maßstabsplatten der Positionsmesseinrichtung an der Maschine angeordnet, gegen die die Abtasteinheiten messen können. Die Maßstabsplatten sind hierbei ortsfest um das jeweilige Bearbeitungswerkzeug platziert.

Die Hauptaufgabe einer derartigen Positionsmesseinrichtung besteht darin, die Position und Lage der Maschinenkomponente mindestens bezüglich der Verschiebungsfreiheitsgrade x, y entlang der Hauptbewegungsachsen X, Y sowie bezüglich des Verdrehungsfreiheitsgrads $R_Z$ um die Z-Achse zu bestimmen. Im Folgenden sei in diesem Zusammenhang von einer sog. 3-DOF-Messung gesprochen (DOF = Degree Of Freedom). Darüberhinaus kann es für hochpräzise Anwendungen erforderlich sein, alle sechs Freiheitsgrade der jeweiligen Maschinenkomponente zu erfassen. Dies wären zusätzlich noch der Verschiebungsfreiheitsgrad z entlang der Z-Achse sowie die Verdrehungsfreiheitsgrade $R_Y$, $R_X$ um die Y- bzw. X-Achse. In diesem Fall sei von einer sog. 6-DOF-Messung die Rede.

Ein solches System, das in der Halbleiterindustrie zur Positionierung eines Wafers (Werkstück) unter einer Belichtungs- oder Inspektionseinheit (Bearbeitungswerkzeug) genutzt wird, ist etwa aus der US 2007/0195296 A1 bekannt. Der Tisch T in einer derartigen Maschine ist hierbei mit einer Positionsmesseinrichtung mit vier kombinierten Abtasteinheiten E1 - E4 gemäß der US 7,573,581 B2 ausgestattet, wie dies in Figur 1 der vorliegenden Anmeldung schematisch dargestellt ist. Über jede Abtasteinheit E1 - E4 werden Abtastsignale bzw. Positionsmesswerte erzeugt, die zwei Richtungskomponenten der Abtasteinheit-Position gegenüber der abgetasteten Maßstabsplatte enthalten:

- Entlang einer vorgegebenen Richtung in der Ebene der Maßstabsplatten; der Positionsmesswert in dieser Richtung sei im Folgenden mit $Y^{(enc)}$ bezeichnet.

- Entlang eines Abstands senkrecht zur Maßstabsplatte; dieser Positionsmesswert sei im Folgenden mit Z bezeichnet, die entsprechende Abstandsmessung als Z-Messung.

Eine Abtasteinheit gemäß der US 7,573,581 B2 kann demzufolge als Kombination einer Abtasteinheit mit einer Messrichtung in der Verschiebeebene XY und einer Abtasteinheit mit einer Messrichtung Z senkrecht zur Verschiebeebene XY betrachtet werden.

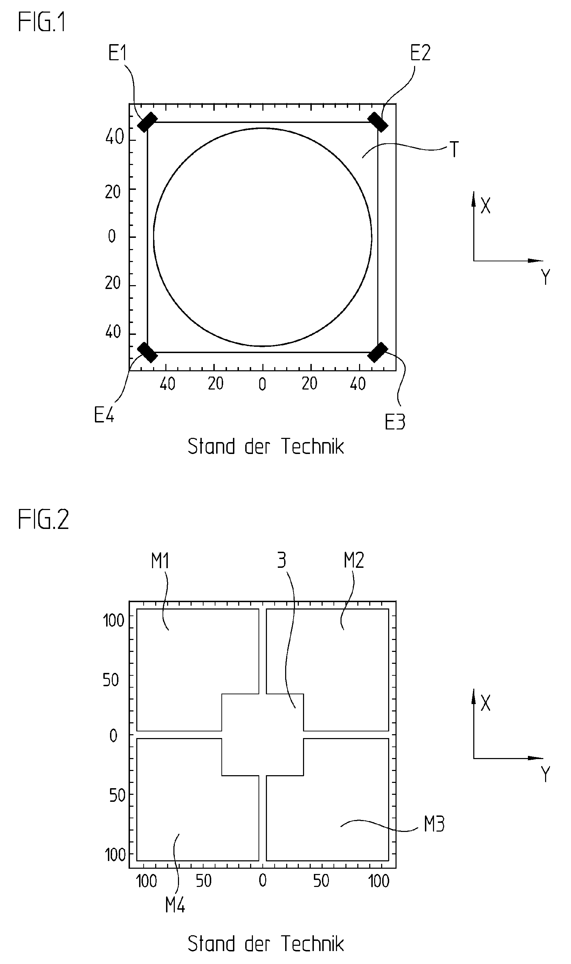

Die Abtasteinheiten E1 - E4 werden an den vier Ecken des Tischs T angebracht und wie aus Figur 1 ersichtlich schräg zu den beiden Hauptbewegungsachsen X, Y ausgerichtet. Je nach Ausrichtung ermitteln die Abtasteinheiten somit entweder Positionsmesswerte $Y^{(enc)} = (X + Y)/\sqrt{2}$ oder Positionsmesswerte $Y^{(enc)} = (X - Y)/\sqrt{2}$. Darüber hinaus liefert jede Abtasteinheit E1 - E4 eine Information bzw. Positionsmesswerte bezüglich ihres Abstands entlang der Z-Achse zur Maßstabsplatte.

Die Abtasteinheiten E1 - E4 messen in der bekannten Anordnung gegenüber vier aneinander angrenzenden, im Karree platzierten Maßstabsplatten M1 - M4, wie dies in Figur 2 dargestellt ist. Die Einheiten der Achsenbeschriftungen in den Figuren 1 und 2 sind im übrigen willkürlich gewählt. Im Zentrum der Maßstabsplatten-Anordnung ist ein größerer Bereich B ausgespart. Hier befindet sich das Bearbeitungswerkzeug, beispielsweise die Belichtungs- oder Inspektionseinheit. Im Maschinenbetrieb kann sich einer der vier Abtasteinheiten E1 - E4 zeitweise unterhalb des ausgesparten Bereiches befinden und währenddessen keine Messwerte liefern. Trotzdem kann die Maschinenposition auch in diesem Fall genau bestimmt werden, denn bereits drei Abtasteinheiten im Eingriff mit den Maßstabsplatten M1 - M4 reichen für die Bestimmung der sechs Freiheitsgrade des Tisches T aus.

Die Genauigkeit der entsprechenden Maschine wird unter anderem durch folgende Störfaktoren entscheidend beeinträchtigt:

- Verzerrungen der Maßstabsplatten M1 - M4 (statisch oder langsam veränderlich im Maschinenbetrieb, sogenannter "Drift", oft verursacht durch Temperaturschwankungen)

- Eigenschwingungen und Vibrationen des Tischs T bzw. der Maschinenkomponente, auf dem sich das Werkstück befindet

Je größer das Werkstück ist, desto wichtiger werden die genannten Störfaktoren, denn für größere Maschinenkomponenten und Maßstabsplatten ist es schwieriger, Schwingungen und Verformungen durch eine versteifte Ausbildung derselbigen zu unterdrücken. Falls jedoch Messdaten über die Maßstabsverformungen und den gegenwärtigen Anregungszustand der Vibrationen der Maschinenkomponente zur Verfügung stehen, können geeignete Maßnahmen zur Kompensation bzw. Dämpfung ergriffen werden.

Derartige Vibrationen der Maschinenkomponente stellen oszillierende Verformungen der Maschinenkomponente dar, beispielsweise des Tisches. Sie führen zu einer Auslenkung der daran angeordneten Abtasteinheiten E1 - E4 gegenüber ihrer angenommenen Position in der (hypothetisch) starren Maschinenkomponente. Folglich stimmt die Position der Maschinenkomponente, die ohne Vibrationen in Betracht zu ziehen direkt aus den Messwerten der Abtasteinheiten E1 - E4 gewonnen wird, nicht mit der tatsächlichen Position der Maschinenkomponente überein. Desweiteren ist die aus der Maschinenkomponenten-Position berechnete Position des Bearbeitungswerkzeugs, also etwa der Belichtungs- oder Inspektionseinheit, relativ zum Werkstück, d.h. zum Wafer, nicht exakt bestimmt, weil das Werkstück im Verbund mit der Maschinenkomponente vibriert und sich dementsprechend verbiegt.

Eine bekannte Möglichkeit Vibrationen von Maschinenkomponenten zu detektieren, beruht auf der Analyse der zeitlichen Historie der Abtasteinheit-Messwerte bzw. der entsprechenden Analyse im Frequenzraum und der Kräfte, die auf die Maschinenkomponente ausgeübt wurden. Hierzu sei beispielsweise auf die US 2011/0317142 A1 verwiesen. Die derart gewonnene Information über die von einer Vibrationsmode verursachte Verbiegung der Maschinenkomponente kann in die Regelung der Aktuatoren derart eingespeist werden, dass der von Vibrationen verursachte Fehler der Position des Bearbeitungswerkzeugs relativ zum Werkstück stark reduziert wird.

Eine solche Vibrationserfassung und Kompensation, die ausschließlich auf einer zeitlichen Analyse der Abtasteinheit-Messwerte beruht, besitzt jedoch eine Reihe von Nachteilen.
Die Vibrationen der Maschinenkomponente werden im Maschinenbetrieb nicht über ein Messsystem detektiert, sondern über ein dynamisches physikalisches Modell abgeschätzt, das die Auswirkung externer Kräfte auf die Maschinenkomponente beschreibt. Das physikalische Modell kann aus theoretischen Berechnungen oder mechanischen Messungen ermittelt werden. Kleine Abweichungen dieses Modells vom realen mechanischen Verhalten sowie nicht erfasste Krafteinwirkungen auf die Maschinenkomponente tragen daher unmittelbar zu einem Positionierungsfehler des Bearbeitungswerkzeugs relativ zum Werkstück bei. Die Abweichungen der Vorhersagen des Modells vom realen Verhalten können im Maschinenbetrieb nicht detektiert werden.
Desweiteren basiert die in der erwähnten US 2011/0317142 A1 vorgeschlagene Zerlegung der Messwerte (und Kräfte) in ein PositionsSignal und ein Vibrations-Signal auf Filtern, die den zeitlichen Verlauf dieser Größen verarbeiten. Die Filter werden z.B. im Frequenzraum als Bandpass- bzw. Notch-Filter angelegt. Um eine derartige Frequenzfilterung durchzuführen muss der zeitliche Signalverlauf über eine Zeitspanne von der Größenordnung einer Periode der Vibrationsoszillation bekannt sein. Folglich führt eine solche Signalverarbeitung zwangsläufig zu einer gewissen Trägheit bzw. zu einer Latenz des Regelsystems zumindest innerhalb der Frequenzbänder, die den Vibrationen zugeordnet werden. Gerade bei schnellen Beschleunigungsvorgängen oder beim Versuch, Oszillationen innerhalb kurzer Zeit aktiv zu dämpfen, ist daher zu erwarten, dass ein träges Regelsystem von Nachteil ist.

Aus den Figuren 3 und 4 der US 2006/0227309 A1 sind Positionsmesseinrichtungen bekannt, die zur Erfassung der Relativposition zweier Maschinenkomponenten dienen, welche mindestens entlang einer ersten Hauptbewegungsrichtung und einer zweiten Hauptbewegungsrichtung in einer Verschiebeebene zueinander beweglich angeordnet sind. Hierbei sind eine Mehrzahl von Abtasteinheiten vorgesehen, die an einer der Maschinenkomponenten angeordnet sind und mehrere Maßverkörperungen auf der anderen Maschinenkomponente optisch abtasten. Die vorgeschlagenen Anordnungen der Abtasteinheiten sind jedoch nicht ideal zur Erfassung eventueller vibrationsbedingter Verbiegungen der Maschinenkomponente, insbesondere zur Erfassung unterschiedlicher Vibrationsmoden.

Die Aufgabe der vorliegenden Erfindung besteht darin, eine Positionsmesseinrichtung zu schaffen, über die zusätzlich zur mindestens möglichen 3-DOF-Bestimmung der Pose einer Maschinenkomponente noch eine möglichst instantane Bestimmung der durch Vibrationen verursachten Verbiegungen der Maschinenkomponente möglich ist.

Diese Aufgabe wird gelöst durch eine Positionsmesseinrichtung mit den Merkmalen des Anspruchs 1.

Vorteilhafte Ausführungsvarianten der erfindungsgemäßen Positionsmesseinrichtung ergeben sich aus den Merkmalen der abhängigen Patentansprüche.

Die erfindungsgemäße Positionsmesseinrichtung dient zur Erfassung der Relativposition zweier Maschinenkomponenten, die mindestens entlang einer ersten Hauptbewegungsrichtung und einer zweiten Hauptbewegungsrichtung in einer Verschiebeebene zueinander beweglich angeordnet sind. Sie umfasst mindestens eine Maßverkörperung, die an einer ersten Maschinenkomponente angeordnet ist und mindestens sechs Abtasteinheiten, die an der zweiten Maschinenkomponente angeordnet sind und zur optischen Abtastung der Maßverkörperung in mindestens zwei Messrichtungen in der Verschiebeebene dienen. Hierbei sind jeder Messrichtung mindestens zwei Abtasteinheiten zugeordnet; ferner sind die Abtasteinheiten jeweils einer Messrichtung in der Verschiebeebene nicht-punktsymmetrisch in Bezug auf ein Zentrum der zweiten Maschinenkomponente angeordnet.

Es ist ferner möglich, mindestens drei weitere Abtasteinheiten vorzusehen, die zur Erfassung der Relativposition der beiden Maschinenkomponenten entlang einer weiteren Richtung ausgebildet sind, wobei diese Richtung senkrecht zur Verschiebeebene orientiert ist.

Mit Vorteil sind die Abtasteinheiten mit gemeinsamen Messrichtungen in der Verschiebeebene nicht auf einer gemeinsamen Verbindungsgeraden angeordnet.

Es kann vorgesehen sein, dass

-   durch zwei senkrecht aufeinander stehende Achsen in der Verschiebeebene, die sich im Zentrum der zweiten Maschinenkomponente kreuzen, ein kartesisches Koordinatensystem mit vier Quadranten ausgebildet ist und
-   in mindestens zwei Quadranten je mindestens zwei Abtasteinheiten mit der jeweils gleichen Messrichtung angeordnet sind.

Alternativ kann auch vorgesehen sein, dass

-   durch zwei senkrecht aufeinander stehende Achsen in der Verschiebeebene, die sich im Zentrum der zweiten Maschinenkomponente kreuzen, ein kartesisches Koordinatensystem mit vier Quadranten ausgebildet ist und
-   in mindestens drei Quadranten je mindestens zwei Abtasteinheiten mit der jeweils gleichen Messrichtung angeordnet sind.

Schließlich kann auch vorgesehen sein, dass

-   durch zwei senkrecht aufeinander stehende Achsen in der Verschiebeebene, die sich im Zentrum der zweiten Maschinenkomponente kreuzen, ein kartesisches Koordinatensystem mit vier Quadranten ausgebildet ist und
-   in allen vier Quadranten je mindestens zwei Abtasteinheiten mit der jeweils gleichen Messrichtung angeordnet sind.

Desweiteren ist es hierbei möglich, dass die Abtasteinheiten, die in diagonal gegenüberliegenden Quadranten angeordnet sind, jeweils alle die gleiche Messrichtung aufweisen.

Es kann desweiteren vorgesehen sein, dass in mindestens drei Quadranten eine weitere Abtasteinheit angeordnet ist, die zur Erfassung der Relativposition der beiden Maschinenkomponenten entlang einer weiteren Richtung ausgebildet ist, wobei diese Richtung senkrecht zur Verschiebeebene orientiert ist.

Schließlich ist es möglich, dass mindestens eine Abtasteinheit für eine Messrichtung in der Verschiebeebene zusammen mit einer Abtasteinheit für eine Messrichtung senkrecht zur Verschiebeebene in einer kombinierten Abtasteinheit integriert ist.

Die erfindungsgemäße Positionsmesseinrichtung kann somit verwendet werden

-   zur Erfassung mehrerer Freiheitsgrade einer beweglich angeordneten Maschinenkomponente und
-   zur Erfassung von Vibrationen der Maschinenkomponente.

Desweiteren kann die erfindungsgemäße Positionsmesseinrichtung verwendet werden, um Fehler der eingesetzten Maßverkörperung zu erfassen.

Die erfindungsgemäße Positionsmesseinrichtung ermöglicht somit die instantane Mit-Erfassung von Vibrationen einer Maschinenkomponente. Es ist hierbei im Unterschied zum Stand der Technik insbesondere keine Messwert-Analyse über einen längeren Zeitraum erforderlich. Unnötige Latenzzeiten bzw. träge Reaktionen im Maschinen-Regelungssystem können vermieden werden, da Informationen zu den vibrationsbedingten Auslenkungen der Maschinenkomponente verzögerungsfrei zur Verfügung stehen.

Als weiterer Vorteil ist zu erwähnen, dass die Messung der vibrationsbedingten Verbiegung der Maschinenkomponente nunmehr direkt an den Messpunkten der Abtasteinheiten der erfindungsgemäßen Positionsmesseinrichtung erfolgt. Bei der Bestimmung der aktuellen Verbiegung muss daher nicht mehr zwingend auf die Vorhersage aus einem aufwändigen und ggf. unzulänglichen dynamischen Modell der Maschinenkomponente zurückgegriffen werden.

Schließlich resultiert über die erfindungsgemäßen Maßnahmen desweiteren eine Möglichkeit, den maximalen Verfahrbereich des Gesamtsystems zu erweitern, ohne dass hierzu eine Vergrößerung der verwendeten Maßverkörperungen erforderlich ist. Es wird somit der Bereich erweitert, innerhalb dessen die Maschinenkomponente verfahren und positioniert werden kann.

Die zusätzlich gewonnenen Messwerte können desweiteren zur Kalibrierung des Systems verwendet werden, also z.B. zur Detektion eventueller Deformationen bzw. Fehler der Maßstabsplatten.

Weitere Vorteile und Einzelheiten der vorliegenden Erfindung ergeben sich aus der Beschreibung von Ausführungsbeispielen anhand der Figuren.

Es zeigt

Figur 1        eine erste schematisierte Darstellung zum Stand der Technik;

Figur 2        eine zweite schematisierte Darstellung zum Stand der Technik;

Figur 3    eine schematisierte Darstellung bezüglich der Auswirkung von Vibrationen auf die Messwerte einer Positionsmesseinrichtung;

Figur 4a - 4e    je eine schematisierte Darstellung bezüglich wichtiger Schwingungsmoden eines quadratischen Tisches;

Figur 5    eine mögliche Anordnung von Abtasteinheiten in einer Positionsmesseinrichtung;

Figur 6    die Anordnung der Abtasteinheiten in einer ersten Ausführungsform der erfindungsgemäßen Positionsmesseinrichtung;

Figur 7    die Anordnung der Abtasteinheiten in einer zweiten Ausführungsform der erfindungsgemäßen Positionsmesseinrichtung;

Figur 8    die Anordnung der Abtasteinheiten in einer dritten Ausführungsform der erfindungsgemäßen Positionsmesseinrichtung.

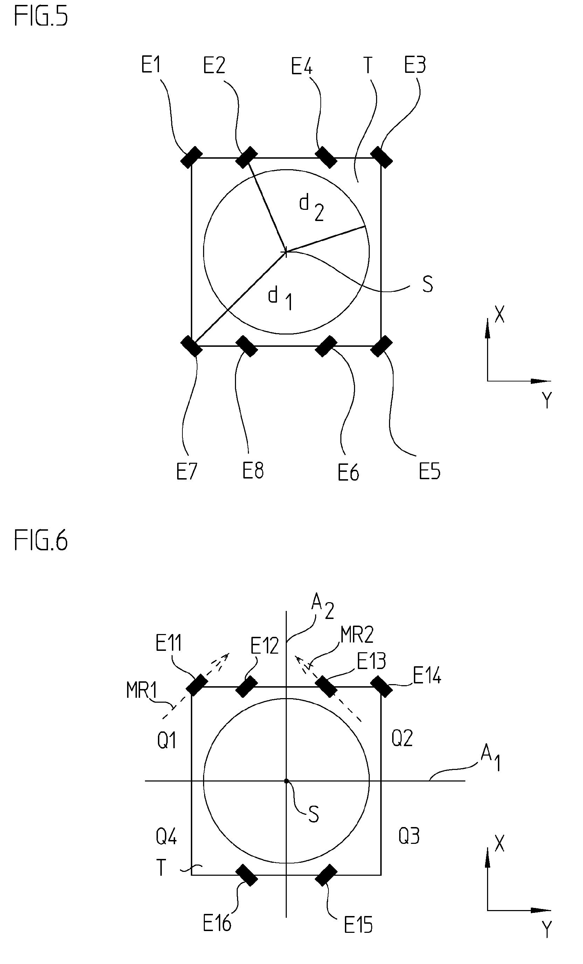

Bevor drei konkrete Ausführungsbeispiele der erfindungsgemäßen drei Positionsmesseinrichtungen anhand der Figuren 6 - 8 erläutert werden, seien vorab zunächst verschiedene theoretische Überlegungen im Zusammenhang mit der vorliegenden Erfindung erörtert.

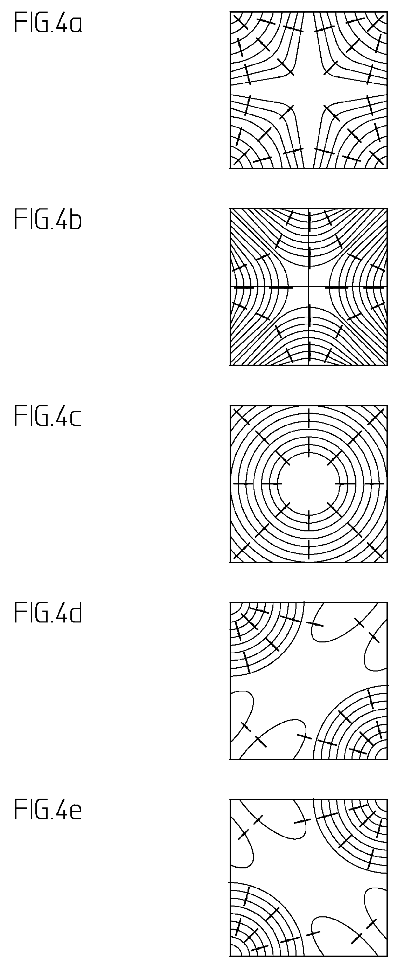

So versursacht jeder Vibrationsmode eine oszillierende Verformung der entsprechenden Maschinenkomponente in einer für die Mode charakteristischen Form. In den Figuren 4a - 4e sind exemplarisch die fünf niederfrequentesten Vibrationsmoden einer homogenen quadratischausgebildeten Maschinenkomponente dargestellt, wobei als Maschinenkomponente ein flacher Tisch vorgesehen ist, auf dem das Werkstück platziert wird. Die Figuren 4a - 4e zeigen hierbei jeweils das Höhenprofil der Maschinenkomponente, d.h. deren Z-Auslenkung. Neben den Höhenlinien sind in diesen Figuren Pfeile eingezeichnet, die in Richtung des jeweiligen Gradienten zeigen. Die einzelnen, an verschiedenen Punkten der Maschinenkomponente montierten Abtasteinheiten einer Positionsmesseinrichtung werden durch diese oszillierenden Verformungen ausgelenkt. Sind die Moden der Maschinenkomponente bekannt, so werden die Positionsmesswerte durch Verbiegungen der Maschinenkomponente in bekannter, von der Position der Abtasteinheiten abhängigen Weise beeinflusst.

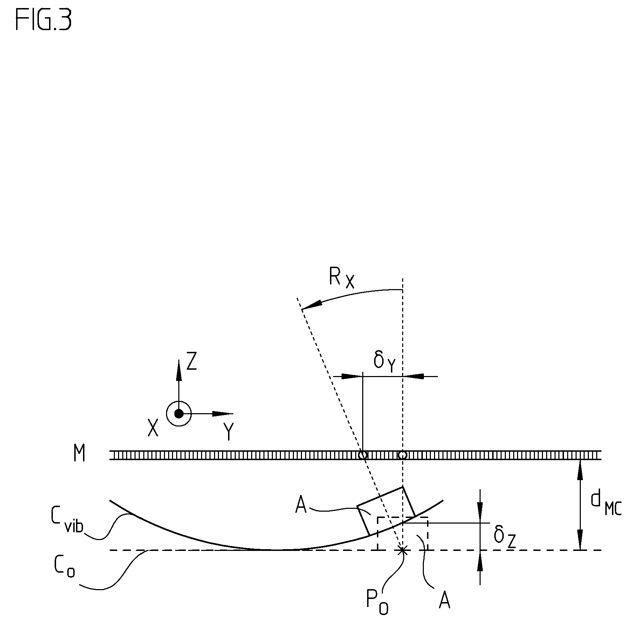

In Figur 3 ist der Mechanismus für kleine Verformungen der Maschinenkomponente bzw. eines Tisches in führender Ordnung dargestellt. Mit dem Bezugszeichen M ist in der Figur hierbei die Maßverkörperung bezeichnet; $C_0$ bezeichnet die Tischoberfläche in einer Ruhelage, welche sich im Abstand $d_{MC}$ von der Maßverkörperung M befinde. In dieser Ebene befindet sich am Punkt $P_0$ eine strichliniert angedeutete Abtasteinheit A. Die Abtasteinheit A muss hierbei nicht zwingend oberhalb der Tischoberfläche $C_0$ angeordnet sein, vielmehr könnte diese auch bezüglich der Tischoberfläche $C_0$ nach unten versenkt angeordnet sein. Die Abtasteinheit A misst gegen die Maßverkörperung M, wie dies in der Figur durch die senkrecht-verlaufende gepunktete Linie angedeutet ist.

Im Maschinenbetrieb bewirken Vibrationen nunmehr oszillierende Verkrümmungen der Tischebene bzw. der Tischoberfläche. In Figur 3 ist beispielhaft eine verkrümmte Tischoberfläche dargestellt, die dort mit $C_{vib}$ bezeichnet ist. Über die auftretende Vibration wird auch die Abtasteinheit A versetzt und verkippt. Die versetzte Abtasteinheit A ist in der Figur mit durchgezogenen Linien dargestellt. Für eine flache Maschinenkomponente können Vibrationsmoden in führender Ordnung als oszillierende Veränderung des Höhenprofils der Maschinenkomponenten-Oberfläche aufgefasst werden. Die Abtasteinheit A wird durch die Vibrationen entlang der Z-Achse um den Betrag $\delta Z$ angehoben bzw. abgesenkt; desweiteren kommt es zu einer Verkippung der Abtasteinheit A um einen Winkel um die X-Achse, der in Figur 3 mit $R_x$ bezeichnet ist. Je nach Messrichtung und Ausbildung der Abtasteinheit A wirken sich Abweichungen $\delta Z$ und $R_x$ gegenüber der Ruhelage auf die erzeugten Positionsmesswerte der Abtasteinheit A aus. Sind die Eigenschaften der Abtasteinheit A bei der resultierenden Verkippung und Verschiebung bekannt, so können die von den Vibrationsmoden verursachten Beiträge zu den Positionsmesswerten aus der momentanen Auslenkung der Maschinenkomponente berechnet werden. Handelt es sich bei der in Figur 3 dargestellten Abtasteinheit A z.B. um eine Abtasteinheit mit einer Messrichtung entlang der Y-Achse und befindet sich der neutrale Drehpunkt der Abtasteinheit A auf der Maßverkörperung M, so ändert sich der erfasste Positionsmesswert entlang der Messrichtung Y aufgrund der Verbiegung der Maschinenkomponente um den Betrag $\delta Y \approx d_{MC} \cdot R_X$. Unter dem neutralen Drehpunkt sei hierbei derjenige Punkt verstanden, um den eine eventuelle Verkippung der Abtasteinheit A keine Veränderung der erzeugten Positionsmesswerte bewirkt. Auf die Näherung in führender Ordnung kann hierbei auch verzichtet werden. Der Zusammenhang zwischen der Auslenkung der Maschinenkomponente und den Positionsmesswerten wird dann zwar komplexer, kann aber weiterhin im Rahmen eines geometrischen Modells berechnet werden.

Sind nur Abtasteinheiten mit Messrichtungen in der Verschiebeebene vorgesehen, so können damit Verkippungen der Maschinenkomponente um die X- bzw. Y-Achse sowie die Z-Position der Maschinenkomponente nicht gemessen bzw. in linearer Ordnung nicht von den Verschiebungsfreiheitsgraden x, y in der Verschiebeebene unterschieden werden. Für die 3-DOF-Bestimmung von Position und Orientierung der Maschinenkomponente müssen also mindestens drei geeignete Positionsmesswerte der Abtasteinheiten zur Verfügung stehen, so dass sich daraus die Koordinaten X,Y sowie der Drehwinkel $R_Z$ der Maschinenkomponente bestimmen lassen; alle weiteren zur Verfügung stehenden Positionsmesswerte können bereits für die Detektion von Vibrationen genutzt werden. Mit einer Gesamtanordnung, die 3+N Abtasteinheiten mit Messrichtungen in der X,Y-Ebene umfasst, können folglich maximal die 3 Freiheitsgrade x, y, $R_Z$ sowie N Vibrationsmoden erfasst werden.

Stehen auch noch mindestens drei Abtasteinheiten mit einer Messrichtung Z zur Verfügung, so kann eine 6-DOF-Bestimmung der Maschinenkomponente erfolgen. Es werden also in diesem Falle mindestens 6 geeignete Positionsmesswerte benötigt, um daraus die Koordinaten X, Y, Z sowie die Drehungen $R_X$, $R_Y$ und $R_Z$ der Maschinenkomponente zu bestimmen; alle darüberhinaus zur Verfügung stehenden Positionsmesswerte können für die Detektion von Vibrationen verwendet werden. Mit einer Anordnung zur 6-DOF-Bestimmung, die insgesamt 6+N Abtasteinheiten aufweist, können neben den 6 Freiheitsgraden der (starren) Maschinenkomponente folglich noch maximal N Vibrationsmoden erfasst werden.

Für die Auswertung der erzeugten Positionsmesswerte müssen die wichtigsten Schwingungsmoden der Maschinenkomponente aus einer Modalanalyse z.B. mittels einer Computersimulation oder einer geeigneten Messung vorab bestimmt worden sein. Für die Auswertung stellt man beispielsweise ein Gleichungssystem auf, das die zu erwartenden Positionsmesswerte für eine gegebene Anordnung von Abtasteinheiten auf der Maschinenkomponente beschreibt. Jede Gleichung gibt einen Positionsmesswert in Abhängigkeit von den gegenwärtigen Vibrationsauslenkungen und von der gegenwärtigen Maschinenkomponentenposition wieder.

Jede mit der Modalanalyse ermittelte Vibrationsmode stellt einen zusätzlichen Freiheitsgrad dar. Formal wird demnach also mit der erfindungsgemäßen Positionsmesseinrichtung mit einer Mehrzahl von Abtasteinheiten mindestens eine 3+N DOF-Messung (bei Beschränkung auf Abtasteinheiten mit Messrichtungen nur in der XY-Verschiebeebene) bzw. eine 6+N DOF-Messung durchgeführt, bei der neben den sechs Freiheitsgraden des starren Körpers noch N zusätzliche Schwingungsfreiheitsgrade gemessen werden. Somit kann praktisch instantan die aktuelle Verbiegung der Maschinenkomponente erfasst werden, sofern diese sich aus den erfassten Vibrationsmoden zusammensetzt und weitere - in der Regel höhere - Moden vernachlässigbar sind.

Das beschriebene Analyseverfahren kann optional mit einer Analyse des zeitlichen Verlaufs der Positionsmesswerte und Kräfte auf die Maschinenkomponente kombiniert werden, beispielsweise auch unter Verwendung von Ansätzen wie sie aus der eingangs erwähnten US 2011/0317142 A1 bekannt sind.

Damit eröffnen sich erfindungsgemäß folgende zusätzliche Möglichkeiten:

- Falls nötig, können mehr Freiheitsgrade unterschieden werden als Positionsmesswerte der Abtasteinheiten zur Verfügung stehen, z.B. durch Aufspaltung in unterschiedliche Eigenfrequenzen,

- Es können Informationen aus vorhergehenden Messungen zur Reduktion instantaner Fluktuationen (z. B. Rauschen) in das Endergebnis einbezogen werden.

- Es ist möglich, die gegenwärtige Amplitude und Phase einer jeden erfassten Mode zu bestimmen. Hierzu kann die zeitliche Ableitung der Auslenkungen verwendet werden. In diesem Fall geht mindestens ein Satz von Positionsmesswerten von einem früheren Messzeitpunkt mit ein.

Mit Hilfe der Amplituden- und Phaseninformationen kann die Beschleunigung der Maschinenkomponente und/oder die Ansteuerung geeigneter Aktuatoren gezielt moduliert werden, so dass Vibrationen der Maschinenkomponente aktiv gedämpft werden. Je nach Maschine ist eventuell auch möglich, die Auswirkungen von Schwingungen auf das Werkstück während des Bearbeitungsvorgangs durch kompensierendes Nachführen der Maschinenkomponenten- oder Werkzeugposition zu reduzieren.

Wenn keine signifikanten Vibrationen der Maschinenkomponente auftreten werden nur sechs Positionsmesswerte für die Bestimmung der sechs Starrkörper-Freiheitsgrade benötigt. Die darüber hinaus zur Verfügung stehenden ("redundanten") Positionsmesswerte können in diesem Fall beispielsweise verwendet werden, um die Maschine zu kalibrieren. U.a. können etwa Verzerrungen der als Maßstabsplatten ausgebildeten Maßverkörperungen erfasst werden. Eine derartige Kalibrierung kann durch geeignete Wahl der Abtastwerte unabhängig von den bekannten Schwingungsmoden erfolgen, z.B. durch eine Abtastung phasenstarr zu der bekannten Schwingungsfrequenz oder durch Mittelung über mindestens eine Schwingungsperiode.

Zusammenfassend geht man demnach folgendermaßen vor, um mittels der erfindungsgemäßen Positionsmesseinrichtung möglichst instantan die durch Vibrationen verursachten Verbiegungen einer Maschinenkomponente zu bestimmen bzw. zu kompensieren:

In der Designphase der Maschine erfolgt eine Modalanalyse der relevanten Maschinenkomponente, beispielsweise über eine Finite-Elemente-Simulation oder geeignete Messungen zur Ermittlung der N wichtigsten Vibrationsmoden.

Im eigentlichen Betrieb der Maschine erfolgt eine Messung der Maschinenkomponenten-Position und der Maschinenkomponente-Vibrationen in Form einer Erfassung von 3+N bzw. 6+N Freiheitsgraden mit der erfindungsgemäßen Positionsmesseinrichtung.

Es ist damit beispielsweise möglich, schwingungsdämpfende Kräfte mittels in die Motorsteuerung eingekoppelter Maschinenkomponenten-Beschleunigungen oder mittels Ansteuerung gesonderter Aktuatoren auf die Maschinenkomponente auszuüben.

Es ist desweiteren möglich, die Maschinenkomponente oder das Bearbeitungswerkzeug zur Kompensation der verbleibenden Vibrationen nachzuführen.

Die Anordnung der Abtasteinheiten in der erfindungsgemäßen Positionsmesseinrichtung sollte hierbei günstig gewählt werden, um möglichst sensitiv bezüglich der zu erfassenden Moden zu sein und einen großen Verfahrbereich zu gewährleisten. Um den Aufwand und die Kosten gering zu halten, sollten möglichst wenige Abtasteinheiten in der erfindungsgemäßen Positionsmesseinrichtung verwendet werden. Grundsätzlich sollten jedoch mindestens drei wichtige Vibrationsmoden über die gewählte Ausgestaltung der erfindungsgemäßen Positionsmesseinrichtung erfassbar sein.

Im Folgenden seien drei konkrete Ausführungsbeispiele der erfindungsgemäßen Positionsmessrichtung anhand der Figuren 6 - 8 beschrieben. Zum besseren Verständnis der erfindungsgemäßen Überlegungen sei vorab anhand von Figur 5 eine Anordnung von acht Abtasteinheiten E1 - E8 in einer Positionsmesseinrichtung erläutert, die gegenüber dem Stand der Technik zwar eine Verbesserung darstellt, jedoch für die angestrebte Erfassung der Maschinenkomponenten-Vibrationen noch nicht optimal geeignet ist.

Wie eingangs erläutert, kann die entsprechende Positionsmesseinrichtung in einer Maschine zur Halbleiterfertigung eingesetzt werden; sie dient hier zur Erfassung der Relativposition zweier Objekte bzw. Maschinenkomponenten, die entlang einer ersten und zweiten Hauptbewegungsachse Y, X zueinander beweglich angeordnet sind. Bei den entsprechenden Maschinenkomponenten kann es sich etwa um eine erste ortsfeste Maschinenkomponente und eine demgegenüber bewegliche Maschinenkomponente wie z.B. einen Tisch T handeln. Der Tisch T ist entlang der orthogonal zueinander orientierten ersten und zweiten Hauptbewegungsachsen Y, X positionierbar. Auf dem Tisch T kann ein Werkstück, beispielsweise ein Wafer, angeordnet werden, der relativ zu einem ortsfesten Bearbeitungswerkzeug positioniert wird.

An der im Beispiel ortsfesten Maschinenkomponente sind ein oder mehrere zweidimensionale Maßverkörperungen in Form von Maßstabsplatten mit darauf angeordneten Kreuzgittern vorgesehen, wie dies etwa bereits in Figur 2 dargestellt ist. An der beweglichen Maschinenkomponente bzw. am Tisch T sind eine Mehrzahl von Abtastköpfen E1 - E8 zur optischen Abtastung der Maßverkörperung(en) vorgesehen. In Bezug auf Details einer möglichen optischen Abtastung und der konkreten Ausgestaltung des Abtastprinzips sei etwa auf die bereits oben erwähnte US 5,573,581 B2 der Anmelderin verwiesen.

Der Tisch T ist in der Verschiebeebene angeordnet, die nachfolgend auch als XY-Ebene bezeichnet sei. Sowohl in Figur 5 als auch in den folgenden Figuren ist der Tisch T vereinfacht rechteckförmig dargestellt; ein kreisförmiges Werkstück kann jeweils im Zentrum S des Tisches T angeordnet werden. Selbstverständlich kann der Tisch T auch alternative Geometrien aufweisen.

Im Beispiel der Figur 5 umfasst die dargestellte Positionsmesseinrichtung insgesamt acht am Tisch T angeordnete Abtasteinheiten E1 - E8. Hierbei sind vier Abtasteinheiten E1, E3, E5 und E7 in den Ecken eines Rechtecks angeordnet. Die Anordnung der vier Abtasteinheiten E1, E3, E5, E7 erfolgt punktsymmetrisch zu einem Zentrum S des Tisches T in einer Anordnungsebene; alle vier Abtasteinheiten E1, E3, E5 und E7 besitzen den gleichen ersten Abstand $d_1$ zum Zentrum S.

Die Abtasteinheiten E1 und E5 bzw. E3 und E7 an den jeweils gegenüberliegenden Ecken des rechteckig dargestellten Tisches T sind parallel ausgerichtet. Dies bedeutet, dass die darin vorgesehenen Gitter zur optischen Abtastung parallel zueinander orientiert sind, so dass ihre jeweiligen Messrichtungen identisch sind. In zwei gegenüberliegenden Ecken wird demzufolge ein Positionsmesswert $Y^{(enc)} = (X + Y)/\sqrt{2}$ gemessen und in den beiden anderen gegenüberliegenden ein Positionsmesswert $Y^{(enc)} = (X - Y)/\sqrt{2}$.

Zu jeder der vier Abtasteinheiten E1, E3, E5 und E7 ist im Beispiel der Figur 5 nunmehr eine weitere Abtasteinheit E2, E4, E6 und E8 mit parallel orientierter Messrichtung am Tisch T in der Anordnungsebene der ersten vier Abtasteinheiten E1, E3, E5 und E7 vorgesehen. Die Y-Koordinaten dieser vier weiteren Abtasteinheiten E2, E4, E6 und E8 sind wie aus Figur 5 ersichtlich gegenüber den Abtasteinheiten E1, E3, E5 und E7 in den Ecken jeweils zum Zentrum S des Tisches T hin verschoben. Die vier weiteren Abtasteinheiten E2, E4, E6 und E8 besitzen demzufolge zweite Abstände $d_2$ zum Zentrum S, die kleiner sind als die ersten Abstände $d_1$ der in den Ecken angeordneten Abtasteinheiten E1, E3, E5 und E7.

Die Symmetrieeigenschaften der Maschinenkomponente bzw. des Tisches T übertragen sich auf die Form der Eigenvibrationen. Wie aus den Figuren 4a - 4e ersichtlich, stellt die Punktsymmetrie bezüglich des Tisch-Schwerpunkts bzw. des Zentrums S eine besonders wichtige Symmetrie dar. Erfüllt der mechanische Aufbau des Tisches (näherungsweise) Punktsymmetrie, dann sind auch die Eigenmoden unter Punktspiegelung (näherungsweise) gerade (d.h. unverändert) oder ungerade (d.h. gleich bis auf das Vorzeichen).

Sind nun Gruppen von Abtasteinheiten zueinander symmetrisch im Sinne der angesprochenen Tisch-Symmetrie angeordnet, dann sind die darüber erzeugten Positionsmesswerte bezüglich der unter Symmetrietransformation geraden (bzw. ungeraden) Vibrationsmoden redundant, denn das von diesen Vibrationen verursachte Signal von den zueinander symmetrischen Abtasteinheitgruppen ist gleich (bzw. gleich bis auf das Vorzeichen). Diese Redundanz ist ungewollt, denn sie reduziert die Anzahl der unabhängigen Informationen über den gegenwärtigen Anregungszustand des Tisches, die mit den vorgesehenen Abtasteinheiten ermittelbar ist.

Besonders zu beachten sind hierbei die drei Vibrationsmoden, die in den Figuren 4a - 4c dargestellt sind. Es ist ersichtlich, dass diese drei Vibrationsmoden unter Punktsymmetrie gerade sind. Es gilt daher in der erfindungsgemäßen Positionsmesseinrichtung die Abtasteinheiten derart anzuordnen, dass eine punktsymmetrische Anordnung der erforderlichen Abtasteinheiten vermieden wird, um bezüglich jeder dieser ersten drei Vibrationsmoden empfindlich zu sein.

Die Abtasteinheit-Anordnung gemäß dem Beispiel aus Figur 5 ist hoch symmetrisch. Es sei nunmehr der typische Fall betrachtet, dass zwei nebeneinander liegende Abtasteinheiten E1 - E8 sich nicht unter einer der mehreren Maßverkörperungen befinden, sondern z. B. im freien zentralen Bereich mit dem Bearbeitungswerkzeug. Es kann sich hierbei etwa um die Abtasteinheiten E7 und E8 aus der in Figur 5 gezeigten Abtasteinheit-Anordnung handeln. Die verbleibenden, aktiven Abtasteinheiten E1 - E6 liefern dann die nachfolgenden Informationen.

Über die drei Abtasteinheiten E1, E3 und E5 in den Ecken stehen bereits ausreichend Information zur Verfügung, um die 6 Starrkörper-Freiheitsgrade des Tisches T zu ermitteln. Die verbleibenden drei Abtasteinheiten E2, E4, E6 liefern Zusatzinformationen für die Vibrationsdetektion. Die Abtasteinheit-Paare E1, E2 sowie E5, E6 sind aber zueinander punktsymmetrisch angeordnet, d.h. die von diesen Abtasteinheiten E1, E2 sowie E5, E6 gelieferten Informationen sind zumindest teilweise redundant. Von daher ist die in Figur 5 gezeigte Anordnung von acht Abtasteinheiten E1 - E8 noch nicht ideal, um die maximal mögliche Information über ggf. vorhandene Vibrationen zu erhalten.

Eine gegenüber Figur 5 optimierte Anordnung von Abtasteinheiten und damit das erste Ausführungsbeispiel der erfindungsgemäßen Positionsmesseinrichtung sei nachfolgend anhand von Figur 6 erläutert.

In Figur 6 ist ein Teil des ersten Ausführungsbeispiels der erfindungsgemäßen Positionsmesseinrichtung dargestellt, nämlich die als beweglicher Tisch T ausgebildete Maschinenkomponente, an der sechs Abtasteinheiten E 11 - E16 in definierter Art und Weise angeordnet sind.

Nicht gezeigt ist in Figur 6 die demgegenüber stationäre Maschinenkomponente, an der mindestens eine Maßverkörperung angeordnet ist. Der Tisch T ist in einer Verschiebeebene entlang der beiden Hauptbewegungsrichtungen Y, X verschiebbar angeordnet. Als Maßverkörperung können hierbei wie bereits in Figur 2 gezeigt mehrere Maßstabsplatten M1 - M4 vorgesehen werden, die jeweils zweidimensionale Kreuzgitter umfassen, welche mittels der Abtasteinheiten E11 - E16 abtastbar sind. Über die Abtasteinheiten E11 - E16 erfolgt hierbei jeweils eine optische Abtastung der Maßverkörperung entlang einer definierten Messrichtung MR1, MR2. Jeder Abtasteinheit E11 - E16 ist demzufolge eine bestimmte Messrichtung MR1, MR2 zuzuordnen. Als Messrichtung MR1, MR2 sei hierbei eine definierte Richtung im dreidimensionalen Raum verstanden. Zum Zeitpunkt der Messung liefert die Abtasteinheit E11 - E16 einen numerischen Wert, den sogenannten Positionswert. Der Positionswert entspricht der Koordinate der Abtasteinheit E11 - E16 bezüglich einer kartesischen Koordinatenachse, deren Orientierung im Raum durch die Messrichtung MR1, MR2 gegeben ist. Die kartesischen Koordinatenachsen müssen hierbei nicht mit den o.g. Hauptbewegungsrichtungen Y, X zusammenfallen.

Im vorliegenden Ausführungsbeispiel erstrecken sich die Messrichtungen MR1, MR2 der Abtasteinheiten E11 - E16 jeweils konkret entlang ihrer Längsachse; dies ist jedoch grundsätzlich nicht zwingend im Rahmen der vorliegenden Erfindung, sondern hängt vom jeweiligen optischen Abtastprinzip ab. Im Hinblick auf die Ausbildung der Abtasteinheiten sei etwa auf die bereits oben erwähnte US 7,573,581 B2 der Anmelderin verwiesen.

Im ersten Ausführungsbeispiel der erfindungsgemäßen Positionsmesseinrichtung dienen die vorgesehenen Abtasteinheiten E11 - E16 zur optischen Abtastung der mindestens einen Maßverkörperung in zwei Messrichtungen MR1, MR2. So ist den drei Abtasteinheiten E11, E12, E15 wie aus Figur 6 ersichtlich eine erste Messrichtung MR1 zugeordnet, die um +45° gegenüber der ersten Hauptbewegungsrichtung Y verkippt ist; den drei Abtasteinheiten E13, E14 und E16 ist die zweite Messrichtung MR2 zugeordnet, die um -45 gegenüber der ersten Hauptbewegungsrichtung Y verkippt ist. Während im vorliegenden Ausführungsbeispiel jeder Messrichtung MR1, MR2 jeweils drei Abtasteinheiten E11, E12, E15 bzw. E13, E14, E16 zugeordnet sind, ist grundsätzlich zumindest erforderlich, in der erfindungsgemäßen Positionsmesseinrichtung jeder Messrichtung mindestens zwei Abtasteinheiten zuzuordnen.

Um die oben diskutierte Redundanz bei der Erfassung der ersten drei Vibrationsmoden zu vermeiden, ist nunmehr erfindungsgemäß vorgesehen, dass die Abtasteinheiten E11, E12, E15 bzw. E13, E14, E16 jeweils einer Messrichtung MR1 bzw. MR2 in der Verschiebeebene nichtpunktsymmetrisch zu einem Zentrum S des Tisches T bzw. der entsprechenden Maschinenkomponente angeordnet sind. So liegt etwa im dargestellten ersten Ausführungsbeispiel keine Punktsymmetrie in Bezug auf die Anordnung der Abtasteinheiten E11, E12, E15 (erste Messrichtung MR1) relativ zum Zentrum S vor. Die Abtasteinheiten E12 und E15 besitzen unterschiedliche Abstände zum Zentrum S; die Verbindungsgerade zwischen den Abtasteinheiten E11 und E15 verläuft nicht durch das Zentrum S. Analog erfolgt die Anordnung der weiteren Abtasteinheiten E13, E14, E16 für die zweite Messrichtung MR2.

Wenn die erfindungsgemäße Positionsmesseinrichtung in einer Maschine zur Halbleiterfertigung eingesetzt wird und die Maschinenkomponente mit den Abtasteinheiten demzufolge der Tisch mit dem Werkstück ist, so können die Abtasteinheiten in der Regel nur in der Nähe der Tischränder angeordnet werden; im Zentrum des Tisches ist üblicherweise das Werkstück platziert. Für die Schwingungsdetektion sind solche Anordnungen zu bevorzugen, bei denen die Abtasteinheiten einer gemeinsamen Messrichtung nicht alle auf einer Kante des Tisches liegen. In diesem Zusammenhang sei etwa die in Figur 4a dargestellte Vibrationsmode betrachtet. Ordnet man Abtasteinheiten mit derselben Messrichtung auf einer geraden Kante des Tisches an, dann ändern sich alle Positionsmesswerte der Abtasteinheiten um etwa denselben Betrag. Diese Änderung kann folglich von einer Positionsänderung des Tisches (oder dessen Kippung um eine Achse in der Verschiebeebene) nicht unterschieden werden. Daher kann es in der erfindungsgemäßen Positionsmesseinrichtung ggf. von Vorteil sein, wenn sich die Abtasteinheiten einer Messrichtung nicht alle auf einer gemeinsamen Gerade befinden.

Im dargestellten ersten Ausführungsbeispiel sind pro Messrichtung MR1, MR2 jeweils drei Abtasteinheiten E11, E12, E15 bzw. E13, E14, E16 vorgesehen. Die pro Messrichtung MR1, MR2 vorgesehenen Abtasteinheiten E11, E12, E15 bzw. E13, E14, E16 sind hierbei derart angeordnet, dass Abtasteinheiten E11 - E16 mit gemeinsamer Messrichtung MR1, MR2 in der Verschiebeebene nicht auf einer gemeinsamen Verbindungsgeraden angeordnet sind.

In Figur 6 sind desweiteren zwei aufeinander senkrecht stehende Achsen $A_1$, $A_2$ in der Verschiebeebene eingezeichnet, die sich im Zentrum S des Tisches T kreuzen. Über diese Achsen $A_1$, $A_2$ wird somit ein kartesisches Koordinatensystem mit Ursprung im Zentrum S und vier Quadranten Q1 - Q4 ausgebildet. Im dargestellten ersten Ausführungsbeispiel der erfindungsgemäßen Positionsmesseinrichtung sind in den zwei Quadranten Q1, Q2 je zwei Abtasteinheiten E11, E12 bzw. E13, E14 angeordnet; die in einem Quadranten Q1 bzw. Q2 angeordneten Abtasteinheiten E11, E12 bzw. E13, E14 weisen jeweils die gleiche Messrichtung MR1, MR2 auf. Sofern in diagonal gegenüberliegenden Quadranten Q1, Q3 bzw. Q2, Q4 Abtasteinheiten E11 - E16 angeordnet sind, kann ferner vorteilhaft sein, dass diese jeweils die gleiche Messrichtung MR1, MR2 aufweisen. Dies bedeutet, dass etwa die Abtasteinheiten E11, E12 und E15 in den diagonal gegenüberliegenden Quadranten Q1, Q3 die gleiche Messrichtung MR1 aufweisen; analog weisen die Abtasteinheiten E13, E14 und E16 in den entsprechenden Quadranten Q2, Q4 die gleiche Messrichtung MR2 auf.

Eine derartige Anordnung erweist sich aus nachfolgenden Überlegungen als vorteilhaft:

Um Drehungen des Tisches T möglichst gut erfassen zu können müssen genügend große Abstände zwischen den Abtasteinheiten E11 - E16 zur Verfügung stehen. Es ist daher günstig, wenn sich nicht alle Abtasteinheiten E11 - E16 in ein und demselben Quadranten Q1 - Q4 des durch die Achsen $A_1$, $A_2$ aufgespannten Koordinatensystems befinden. Gleichzeitig soll trotz begrenzt großer Maßstabsplatten ein möglichst großer Verfahrbereich ermöglicht werden, in dem eine Positionsbestimmung des Tisches T möglich ist. Diesen beiden Forderungen kann man nachkommen, indem man wie oben skizziert jeweils mindestens zwei Abtasteinheiten E11 - E16 gleicher Messrichtung MR1, MR2 in zwei unterschiedlichen Quadranten Q1 - Q4 des erwähnten Koordinatensystems fordert. Die zwei Abtasteinheiten E11, E12 bzw. E13, E14 gleicher Messrichtung MR1 bzw. MR2 gewährleisten eine Positionsbestimmung auch dann, wenn eine der beiden Abtasteinheiten nicht unter einer Maßstabsplatte liegt.

Zusätzlich zu den vorgesehenen Abtasteinheiten E11 - E16 mit Messrichtungen MR1, MR2 in der Verschiebeebene des Tisches T kann in der erfindungsgemäßen Positionsmesseinrichtung vorgesehen werden, dass mindestens drei weitere - nicht dargestellte - Abtasteinheiten am Tisch T angeordnet werden, über die eine Erfassung der Relativposition des Tisches T entlang einer weiteren Achse möglich ist; üblicherweise handelt es sich hierbei um die Z-Achse, die senkrecht zur Verschiebeebene orientiert ist und entlang der im Maschinenbetrieb ebenfalls eine Tischbewegung resultieren kann. Auf diese Art und Weise können dann alle 6 Translations- und Rotationsfreiheitsgrade des Tisches erfasst werden. Vorzugsweise erfolgt die Anordnung dieser zusätzlichen Abtasteinheiten so, dass in mindestens drei der in Figur 6 gezeigten Quadranten Q1 - Q4 eine solche Abtasteinheit platziert wird.

Besonders vorteilhaft ist hierbei zudem, wenn die Abtasteinheiten E11 - E16 mit Messrichtungen MR1, MR2 in der Verschiebeebene mit den zusätzlichen Abtasteinheiten für Messrichtungen senkrecht zur Verschiebeebene in einer kombinierten Abtasteinheit integriert werden.

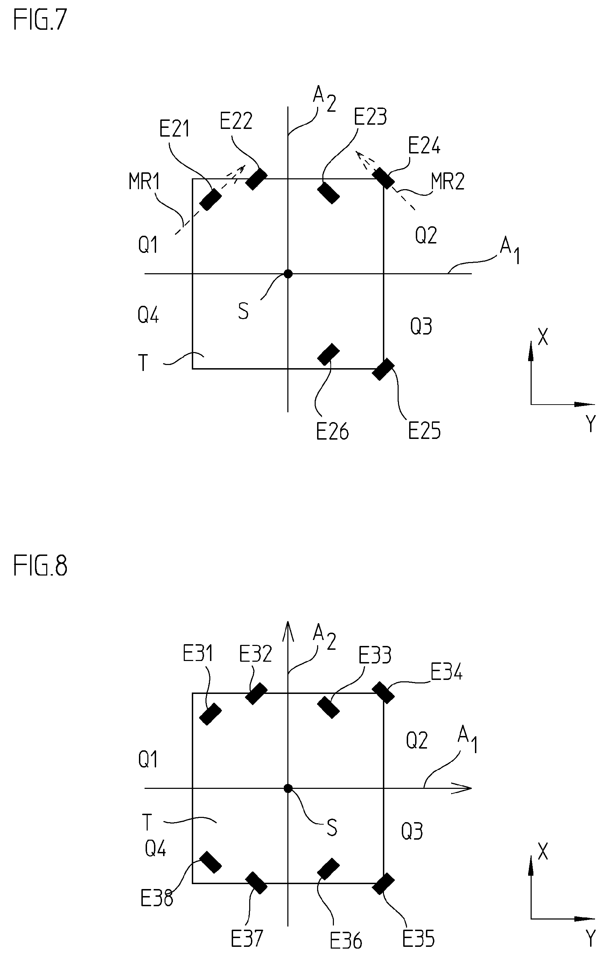

Ein zweites Ausführungsbeispiel der erfindungsgemäßen Positionsmesseinrichtung ist analog zur Darstellung der Figur 6 in Figur 7 gezeigt. Nachfolgend seien im wesentlichen nur die maßgeblichen Unterschiede zum ersten Ausführungsbeispiel erläutert.

Vorgesehen sind wiederum sechs Abtasteinheiten E21 - E26, die in definierter Art und Weise am Tisch T bzw. der entsprechenden Maschinenkomponente angeordnet sind.

Es werden wie aus der Figur ersichtlich jeweils zwei Abtasteinheiten E21/E22, E23/E24 und E25/E26 gleicher Messrichtung MR1, MR2 in mindestens drei Quadranten Q1 - Q3 des erwähnten Koordinatensystems angeordnet. Der Vorteil dieser Anordnung besteht darin, dass alle Abtasteinheiten E21 - E26 relativ weit vom Zentrum S des Tisches entfernt angeordnet werden können. Dadurch ist eine besonders gute Vibrationserfassung möglich, gleichzeitig bleibt ein großer Verfahrweg des Tisches T gewährleistest.

Vorzugsweise werden in diagonal gegenüberliegende Quadranten Q1, Q3 bzw. Q2, Q4 Abtasteinheiten E21 - E26 mit gleichen Messrichtungen MR1, MR2 angeordnet; dies ist vorliegend bei den Quadranten Q1, Q3 und den Abtasteinheiten E21, E21, E25 und E26 gewährleistet. In diesem Fall ist in den gegenüberliegenden Quadranten Q1, Q3 bzw. Q2, Q4 besonders darauf zu achten, dass keine Punktsymmetrie bei der Anordnung der Abtasteinheiten bzgl. des Zentrums S resultiert. Im dargestellten Ausführungsbeispiel wird dieser Forderung etwa nachgekommen, in dem Abtasteinheit E21 näher am Zentrum S des Tisches T angeordnet wird als die Abtasteinheit E25.

Auch dieses Ausführungsbeispiel kann wie oben erläutert um zusätzliche Abtasteinheiten ergänzt werden, die zur Erfassung von Tischbewegungen entlang der Z-Achse dienen.

Abschließend sei ein drittes Ausführungsbeispiel der erfindungsgemäßen Positionsmesseinrichtung anhand der Figur 8 erläutert, wobei nachfolgend wiederum nur auf die maßgeblichen Unterschiede zu den ersten beiden Varianten eingegangen sei.

So kann ein ausgedehntes Bearbeitungswerkzeug in einer entsprechenden Maschine es notwendig machen, einen großen Bereich im Zentrum der Maßstabsplatten auszusparen. Abtasteinheiten, die sich unter dem Bearbeitungswerkzeug befinden, liefern dann keine Positionswerte.

Indem gemäß dem dritten Ausführungsbeispiel der erfindungsgemäßen Positionsmesseinrichtung jeweils mindestens zwei Abtasteinheiten E31/E32, E33/E34, E35/E36, E37/E38 in allen vier Quadranten Q1 - Q4 des oben eingeführten beschriebenen Koordinatensystems angeordnet werden, bleibt die gewünschte Positions- und Vibrationserfassung trotzdem möglich. Befindet sich das Bearbeitungswerkzeug beispielsweise über einem der vier Quadranten Q1 - Q4, so kann mit den Positionsmesswerten aus den Abtasteinheiten der anderen drei Quadranten Q1 - Q4 immer noch gemäß den ersten beiden Ausführungsbeispielen gemessen werden.

Auch in Bezug auf dieses Ausführungsbeispiel gelten die oben erwähnten geometrischen Überlegungen; ebenso sind auch hier die diskutierten Erweiterungen mit zusätzlichen Abtasteinheiten möglich.

Neben den erläuterten Varianten gibt es im Rahmen der vorliegenden Erfindung selbstverständlich noch eine Vielzahl weiterer Ausführungsmöglichkeiten.

**Patentansprüche**

1. Positionsmesseinrichtung zur Erfassung der Relativposition zweier Maschinenkomponenten, die mindestens entlang einer ersten Hauptbewegungsrichtung (Y) und einer zweiten Hauptbewegungsrichtung (X) in einer Verschiebeebene zueinander beweglich angeordnet sind, mit

   - mindestens einer Maßverkörperung, die an einer ersten Maschinenkomponente angeordnet ist und
   - mindestens sechs Abtasteinheiten (E11 - E16; E21 - E26; E31 - E38), die an der zweiten Maschinenkomponente angeordnet sind und zur optischen Abtastung der Maßverkörperung in mindestens zwei Messrichtungen (MR1, MR2) in der Verschiebeebene dienen, wobei

     - jeder Messrichtung (MR1, MR2) mindestens zwei Abtasteinheiten (E11 - E16; E21 - E26; E31 - E38) zugeordnet sind und
     - durch zwei senkrecht aufeinander stehende Achsen ($A_1$, $A_2$) in der Verschiebeebene, die sich im Zentrum (S) der zweiten Maschinenkomponente kreuzen, ein kartesisches Koordinatensystem mit vier Quadranten (Q1 - Q4) ausgebildet ist und
     - in mindestens zwei diametral gegenüberliegenden Quadranten (Q1, Q3; Q2, Q4) Abtasteinheiten (E11 - E16; E21 - E26; E31 - E38) mit gleichen Messrichtungen (MR1, MR2) angeordnet sind, wobei für die Anordnung dieser Abtasteinheiten (E 11 - E16; E21 - E26; E31 - E38) keine Punktsymmetrie bezüglich des Zentrums (S) resultiert.

2. Positionsmesseinrichtung nach Anspruch 1 mit mindestens drei weiteren Abtasteinheiten, die zur Erfassung der Relativposition der beiden Maschinenkomponenten entlang einer weiteren Richtung (Z) ausgebildet sind, wobei diese Richtung senkrecht zur Verschiebeebene orientiert ist.

3. Positionsmesseinrichtung nach Anspruch 1, wobei die Abtasteinheiten (E11 - E16) mit gemeinsamen Messrichtungen (MR1, MR2) in der Verschiebeebene nicht auf einer gemeinsamen Verbindungsgeraden angeordnet sind.

4. Positionsmesseinrichtung nach Anspruch 1, wobei

   - in mindestens zwei Quadranten (Q1, Q2) je mindestens zwei Abtasteinheiten (E11, E12, E13, E14) mit der jeweils gleichen Messrichtung (MR1, MR2) angeordnet sind.

5. Positionsmesseinrichtung nach Anspruch 1, wobei

   - in mindestens drei Quadranten (Q1, Q2, Q3) je mindestens zwei Abtasteinheiten (E21, E22, E23, E24, E25, E26) mit der jeweils gleichen Messrichtung (MR1, MR2) angeordnet sind.

6. Positionsmesseinrichtung nach Anspruch 1, wobei

- in allen vier Quadranten (Q1, Q2, Q3, Q4) je mindestens zwei Abtasteinheiten (E21, E22, E23, E24, E25, E26, E31, E32, E33, E34, E35, E36, E37, E38) mit der jeweils gleichen Messrichtung (MR1, MR2) angeordnet sind.

7. Positionsmesseinrichtung nach einem der Ansprüche 4, 5 oder 6, wobei die Abtasteinheiten (E11 - E16; E21 - E26; E31 - E38), die in diagonal gegenüberliegenden Quadranten (Q1 - Q4) angeordnet sind, jeweils alle die gleiche Messrichtung (MR1, MR2) aufweisen.

8. Positionsmesseinrichtung nach einem der Ansprüche 4, 5 oder 6, wobei in mindestens drei Quadranten eine weitere Abtasteinheit angeordnet ist, die zur Erfassung der Relativposition der beiden Maschinenkomponenten entlang einer weiteren Richtung ausgebildet ist, wobei diese Richtung senkrecht zur Verschiebeebene orientiert ist.

9. Positionsmesseinrichtung nach mindestens einem der vorhergehenden Ansprüche, wobei mindestens eine Abtasteinheit für eine Messrichtung in der Verschiebeebene zusammen mit einer Abtasteinheit für eine Messrichtung senkrecht zur Verschiebeebene in einer kombinierten Abtasteinheit integriert ist.

10. Verwendung einer Positionsmesseinrichtung nach mindestens einem der vorhergehenden Ansprüche

- zur Erfassung mehrerer Freiheitsgrade einer beweglich angeordneten Maschinenkomponente und
- zur Erfassung von Vibrationen der Maschinenkomponente.

11. Verwendung einer Positionsmesseinrichtung nach Anspruch 10 sowie zur Erfassung von Fehlern der eingesetzten Maßverkörperung.

**Claims**

1. Position measuring device for detecting the relative position of two machine components which, at least along a first main movement direction (Y) and a second main movement direction (X), are arranged movably in relation to one another in a displacement plane, comprising

- at least one measurement standard which is arranged at the first machine component and
- at least six scanning units (E11-E16; E21-E26; E31-E38) which are arranged at the second machine component and serve for optical scanning of the measurement standard in at least two measurement directions (MR1, MR2) in the displacement plane,

wherein

- at least two scanning units (E11-E16; E21-E26; E31-E38) are assigned to each measurement direction (MR1, MR2) and
- a Cartesian coordinate with four quadrants (Q1-Q4) is formed by two mutually perpendicular axes ($A_1$, $A_2$) in the displacement plane, said axes crossing in the centre (S) of the second machine component, and
- scanning units (E11-E16; E21-E26; E31-E38) with the same measurement directions (MR1, MR2) are arranged in at least two diametrically opposite quadrants (Q1, Q3; Q2, Q4), with no point symmetry in relation to the centre (S) arising for the arrangement of these scanning units (E11-E16; E21-E26; E31-E38).

2. Position measuring device according to Claim 1, comprising at least three further scanning units which are embodied to detect the relative position of the two machine components along a further direction (Z), this direction being oriented perpendicular to the displacement plane.

3. Position measuring device according to Claim 1, wherein the scanning units (E11-E16) with common measurement directions (MR1, MR2) are not arranged on a common connecting line in the displacement plane.

4. Position measuring device according to Claim 1, wherein

- at least two scanning units (E11, E12, E13, E14), each with the same measurement direction (MR1, MR2), are respectively arranged in at least two quadrants (Q1, Q2).

5. Position measuring device according to Claim 1, wherein

- at least two scanning units (E21, E22, E23, E24, E25, E26), each with the same measurement direction (MR1, MR2), are respectively arranged in at least three quadrants (Q1, Q2, Q3).

6. Position measuring device according to Claim 1, wherein

- at least two scanning units (E21, E22, E23, E24, E25, E26, E31, E32, E33, E34, E35, E36, E37, E38), each with the same measurement direction (MR1, MR2), are respectively arranged in all four quadrants (Q1, Q2, Q3, Q4).

**7.** Position measuring device according to one of Claims 4, 5 or 6, wherein the scanning units (E11-E16; E21-E26; E31-E38) which are arranged in diagonally opposite quadrants (Q1-Q4) respectively all have the same measurement direction (MR1, MR2).

**8.** Position measuring device according to one of Claims 4, 5 or 6, wherein a further scanning unit is arranged in at least three quadrants, said further scanning unit being embodied to detect the relative position of the two machine components along a further direction, with this direction being oriented perpendicular to the displacement plane.

**9.** Position measuring device according to at least one of the preceding claims, wherein at least one scanning unit for a measurement direction in the displacement plane is integrated in a combined scanning unit together with a scanning unit for a measurement direction perpendicular to the displacement plane.

**10.** Use of a position measuring device according to at least one of the preceding claims,

   - for detecting a plurality of degrees of freedom of a movably arranged machine component and
   - for detecting vibrations of the machine components.

**11.** Use of a position measuring device according to Claim 10 and for detecting errors of the employed measurement standard.

**Revendications**

**1.** Dispositif de mesure de position pour la détection de la position relative de deux composants de machine qui sont disposés mobile l'un par rapport à l'autre au moins le long d'une première direction de mouvement principale (Y) et d'une deuxième direction de mouvement principale (X) dans un plan de déplacement, comportant

   - au moins une mesure matérialisée qui est disposée sur un premier composant de machine eL
   - au moins six unités de balayage (E11 - E16 ; E21 - E26 ; E31 - E38) qui sont disposées sur le deuxième composant de machine et sont utilisées pour effectuer un balayage optique de la mesure matérialisée dans au moins deux directions de mesure (MR1, MR2) dans le plan de déplacement, dans lequel
   - au moins deux unités de balayage (E11 - E16 ; E21 - E26 ; E31 - E38) sont associées à chaque direction de mesure (MR1, MR2) et
   - un système de coordonnées cartésien à quatre quadrants (Q1 - Q4) est réalisé par deux axes (A$_1$, A$_2$) perpendiculaires l'un à l'autre dans le plan de déplacement, qui se coupent au centre (S) du deuxième composant de machine, et
   - des unités de balayage (E11 - E16 ; E21 - E26 ; E31 - E38) ayant les mêmes directions de mesure (MR1, MR2) sont disposées dans au moins deux quadrants diamétralement opposés (Q1, Q3 ; Q2, Q4), dans lequel il ne résulte aucune symétrie ponctuelle par rapport au centre (S) pour l'agencement desdites unités de balayage (E11 - E16 ; E21 - E26 ; E31 - E38).

**2.** Dispositif de mesure de position selon la revendication 1, comportant au moins trois autres unités de balayage qui sont conçues pour la détection de la position relative des deux composants de machine le long d'une autre direction (Z), dans lequel ladite direction est orientée perpendiculairement au plan de déplacement.

**3.** Dispositif de mesure de position selon la revendication 1, dans lequel les unités de balayage (E11 - E16) ayant des directions de mesure communes (MR1, MR2) dans le plan de déplacement ne sont pas disposées sur une droite de jonction commune.

**4.** Dispositif de mesure de position selon la revendication 1, dans lequel

   - au moins deux unités de balayage respectives (E11, E12, E13, E14) sont respectivement agencées dans la même direction de mesure (MR1, MR2) dans au moins deux quadrants (Q1, Q2).

**5.** Dispositif de mesure de position selon la revendication 1, dans lequel

   - au moins deux unités de balayage respectives (E21, E22, E23, E24, E25, E26) sont respectivement disposées dans la même direction de mesure (MR1, MR2) dans au moins trois quadrants (Q1, Q2, Q3).

**6.** Dispositif de mesure de position selon la revendication 1, dans lequel

   - au moins deux unités de balayage respectives (E21, E22, E23, E24, E25, E26, E31, E32, E33, E34, E35, E36, E37, E38) sont respectivement disposées dans la même direction de mesure (MR1, MR2) dans la totalité des quatre quadrants (Q1, Q2, Q3, Q4).

**7.** Dispositif de mesure de position selon l'une quelconque des revendications 4, 5 ou 6, dans lequel les unités de balayage (E11 - E16 ; E21 - E26 ; E31 - E38) qui sont disposées dans des quadrants diagonalement opposés (Q1 - Q4) présentent toutes respectivement la même direction de mesure (MR1, MR2).

8. Dispositif de mesure de position selon l'une quelconque des revendications 4, 5 ou 6, dans lequel une autre unité de balayage est disposée dans au moins trois quadrants, laquelle autre unité de balayage est conçue pour la détection de la position relative des deux composants de machine le long d'une autre direction, dans lequel ladite direction est orientée perpendiculairement au plan de déplacement.

9. Dispositif de mesure de position selon au moins l'une quelconque des revendications précédentes, dans lequel au moins une unité de balayage destinée à une direction de mesure dans le plan de déplacement est intégrée dans une unité de balayage combinée en association avec une unité de balayage destinée à une direction de mesure perpendiculaire au plan de déplacement.

10. Utilisation d'un dispositif de mesure de position selon au moins l'une quelconque des revendications précédentes

    - pour la détection de plusieurs degrés de liberté d'un composant de machine disposé de manière mobile et
    - pour la détection de vibrations du composant de machine.

11. Utilisation d'un dispositif de mesure de position selon la revendication 10 également destiné à la détection de défauts de la mesure matérialisée utilisée.

FIG.1

Stand der Technik

FIG.2

Stand der Technik

FIG.3

FIG.4a

FIG.4b

FIG.4c

FIG.4d

FIG.4e

FIG.5

FIG.6

FIG.7

FIG.8

**IN DER BESCHREIBUNG AUFGEFÜHRTE DOKUMENTE**

**In der Beschreibung aufgeführte Patentdokumente**

- US 20070195296 A1
- US 7573581 B2
- US 20110317142 A1
- US 20060227309 A1
- US 5573581 B2